# EUROPÄISCHE PATENTSCHRIFT

(11) **EP 2 345 084 B1**
(45) Veröffentlichungstag und Bekanntmachung des Hinweises auf die Patenterteilung: **03.07.2013**
(21) Anmeldenummer: 09784019.3
(22) Anmeldetag: 15.10.2009
(51) Int. Cl.: H01L 31/0216, H01L 31/0224, H01L 31/068

(54) **SOLARZELLE UND VERFAHREN ZU DEREN HERSTELLUNG**
SOLAR CELL AND METHOD FOR PRODUCING THE SAME
CELLULE SOLAIRE ET PROCÉDÉ DE FABRICATION

(30) Priorität: 31.10.2008 DE 102008054092; 03.04.2009 DE 102009016268
(43) Veröffentlichungstag der Anmeldung: 20.07.2011
(73) Patentinhaber: Robert Bosch GmbH, 70469 Stuttgart (DE)
(72) Erfinder: KROKOSZINSKI, Hans-Joachim, 69226 Nußloch (DE)
(86) Internationale Anmeldenummer: PCT/EP2009/063448
(87) Internationale Veröffentlichungsnummer: WO 2010/049275

(56) Entgegenhaltungen:
- WO-A2-2007/126441
- WO-A2-2008/115814
- US-A- 4 927 770
- US-A1- 2006 060 238
- GREEN M A ET AL: "Crystalline silicon on glass (CSG) thin-film solar cell modules" SOLAR ENERGY, PERGAMON PRESS. OXFORD, GB, Bd. 77, Nr. 6, 1. Dezember 2004 (2004-12-01), Seiten 857-863, XP004661826 ISSN: 0038-092X

## Beschreibung

Die Erfindung bezieht sich auf das Sachgebiet der Halbleiter-Bauelemente, insbesondere der Solarzellen, und betrifft insbesondere eine Solarzelle mit einem Halbleitersubstrat, in dessen Rückseite zueinander benachbart Emitterbereiche und hochdotierte Basisbereiche vorgesehen sind, und einer auf dieser Hauptoberfläche angeordneten Passivierungsschicht, welche Durchbrüche zur lokalen Kontaktierung der Emitter- und Basisbereiche mit einer ersten bzw. zweiten Metallschicht aufweist.

Silizium-Solarzellen mit p-Basis und einer vorderseitigen n-Emitterschicht werden seit vielen Jahren auf der Rückseite mit einer ganzflächigen Metallisierung des rückseitigen Basisbereichs zur Verspiegelung und zur elektronischen Passivierung mittels Bandverbiegung (Back Surface Field BSF) versehen. Diese Rückseitenmetallisierung besteht in der Regel aus großflächig aufgedruckter Aluminium-basierter Dickschichtpaste, die sich beim Sintern oberhalb von 800°C durch Bildung des niederschmelzenden (577°C) AlSi-Eutektikums und Rekristallisation an die Halbleiteroberfläche anlegiert und dadurch die p⁺-Dotierung erzeugt.

Bereits vor vielen Jahren wurde in A.W. Blakers et al., Appl. Phys. Lett., 55 (1989), p. 1363-1365 vorgeschlagen, die elektronische Passivierung mittels Dickschichtmetallisierung durch eine dielektrische (meist oxidische oder nitridische) Passivierschicht zu ersetzen, wobei die elektrische Anbindung der großflächigen Dünnschichtmetallisierung an die Halbleiteroberfläche durch kleine, meist regelmäßig in Matrixpositionen angeordnete Punktkontakte (Local Back Surface Field = Local BSF) erreicht wird. Dabei ist vorteilhaft, dass eine einzige Dünnfilm-Metallschicht ausreicht, um alle Kontaktpunke, die meist ca. 0.5 - 1.5 mm von einander entfernt sind, untereinander und mit den rückseitigen Silber-Busbars oder -Lötpads zu verbinden. Diese sog. "Passivated Emitter and Rear Contacts"(PERC)-Struktur, hat inzwischen in vielfachen Varianten Eingang in die neuesten, auch industrielle Zellstrukturen gefunden (industrial PERC = iPERC), vgl. G. Agostinelli et al., 20th European Photovoltaic Solar Energy Conference (2005), Barcelona, Spain, p. 647 und P. Choulat et al, 22nd European Photovoltaic Solar Energy Conference (2007), Milano, Italy.

Die bekannteste Art der lokalen BSF-Kontakte sind die sog. "Laser Fired Contacts" (LFC), bei denen durch Laserbeschuss die besagte Dünnfilm-Metallschicht, meist Aluminium, durch die Oxidschicht hindurch mit der Halbleiteroberfläche verschmolzen wird; vgl. E. Schneiderlöchner et al., Program in Photovoltaics: Research and Applications 10 (2002), S. 29.

Reine Rückseitenkontakt-Solarzellen, d.h. Solarzellen mit nebeneinander liegenden Emitter- und Basis-Bereichen, werden auf monokristallinen n-Si-Wafern bereits seit einigen Jahren von verschiedenen Solarzellenherstellern entwickelt und auch schon auf dem Markt angeboten. Marktgängig ist eine sogenannte Interdigitated Back Contact Zelle (IBC), bei der die Emitter- und die BSF- bzw. Basisbereiche auf der Zellenrückseite durch zwei in einander greifende Gabelstrukturen kontaktiert werden, die beide jeweils eigene, linear angeordnete lokale, d.h. durch die Passivierschicht gebohrte Kontaktpunkte untereinander verbinden. Als Quellen hierzu wird hingewiesen auf W. P. Mulligan, D. H. Rose, M. J. Cudzinovic, D. M. DeCeuster, K. R. McIntosh, D. D. Smith, R. M. Swanson, "Manufacture of solar cells with 21% efficiency"; Proceedings of the 19th European Photovoltaic Solar Energy Conference, Paris, France (2004), R.J. Schwartz, Review of Silicon Solar Cells for High Concentrations, Solar Cells, 6, (1982), Seite 17-38, Martin A. Green, Silicon Solar Cells - Advanced Principles and Practice, Centre for Photovoltaic Devices and Systems, University of New South Wales, Sidney, Australia, 1995, S. 255 ff.., D. Huljic et al, Development of a 21% Back-Contact Monocrystaline Silicon Solar Cell for Large-Scale Production, Proceedings of the 21st EPVSEC, Dresden, 2006, S. 765 und DE 696 31 815 T2.

Die PERC-Struktur ist für beidseitig kontaktierte Solarzellen ein gangbares Zukunftskonzept. Für reine Rückseitenkontaktzellen ist sie allerdings nicht anwendbar, weil hier die Trennung von n- und p-Bereichen vorgesehen werden muss und somit die großflächige Metallisierung allein nicht ausreicht.

Die bisherigen Rückseitenkontakt-/Rückseitenemitter-Solarzellen beruhen daher auf dem IBC-Konzept mit streifigen n- und p-Bereichen, das aber den Nachteil hat, dass es, wie auch immer die lokalen Kontakte in diesen Streifen hergestellt werden, lange dünne Metallbahnen für die Zusammenführung der Strombahnen zu den jeweiligen Außenkontakten benötigt. Es leidet damit immer unter dem Problem, dass der mit zunehmender Länge und abnehmender Breite der Finger steigende Serienwiderstand den Füllfaktor der Solarzelle herabsetzt.

Die wesentlichen Nachteile des Verfahrens der lasererzeugten lokalen Kontaktierung (LFC) sind, dass
a) die Vielzahl der lokalen Kontakte (bis zu vielen Tausend pro Wafer) sequentiell und deshalb in möglichst hoher Zahl pro Sekunde und deshalb mit hoher Lichtintensität hergestellt werden muss,
b) beim hochenergetischen punktuellen Verschmelzen des Aluminiums mit dem Silizium durch die Oxidschicht hindurch eine Schädigung der Silizium-Oberfläche unter den lokalen Kontakten erfolgt, die sich insbesondere in einer erhöhten Oberflächenrekombinationsgeschwindigkeit und damit einer reduzierten Passivierungswirkung äußert;
c) die LFC-Kontaktierung nur auf der Rückseite von p-Basis-Wafem funktioniert, weil nur dort das einlegierte Aluminium die richtige Dotierpolaritat für ein lokales Back Surface Field mitbringt, und
d) die LFC-Kontaktierung wegen der vorgenannten Nachteile nicht für die Herstellung von reinen Rückseitenkontaktzellen, auch nicht von IBC-Zellen, geeignet ist.

Der Erfindung liegt dementsprechend die Aufgabe zu Grunde, eine verbesserte Solarzelle der eingangs genannten Art sowie ein Verfahren zu deren Herstellung anzugeben, die eine einfache und kostengünstige Herstellung mit hoher Ausbeute ermöglichen. Insbesondere geht es hierbei um Solarzellenstrukturen mit rückseitigem passivierten Emitter hoher Flächendeckung und mit kleinen BSF-Bereichen.

Diese Aufgabe wird in ihrem Vorrichtungsaspekt durch eine Solarzelle mit den Merkmalen des Anspruchs 1 und in ihrem Verfahrensaspekt durch ein Verfahren mit den Merkmalen des Anspruchs 11 gelöst. Zweckmäßige Fortbildungen des Erfindungsgedankens sind Gegenstand der jeweiligen abhängigen Ansprüche.

Die Erfindung geht von der Überlegung aus, eine einfache, speziell simultane Herstellung aller lokalen Kontakte zum Emitter und zu den BSF-Bereichen und eine alle lokalen Kontakte einer Polarität verbindende großflächige, niederohmige Metallisierung der Rückseite zu ermöglichen.

Die erfindungsgemäße Multilayer-Dünnschichtmetallisierung für eine Ruckseitensolarzelle erfüllt in vorteilhaften Ausführungen alle Erfordernisse für die Erzeugung einer lokalen Kontaktierung der Halbleiteroberfläche der Solarzelle, sowohl der Emitterbereiche als auch der benachbarten BSF-Bereiche, und für die niederohmige Stromführung von den lokalen Kontakten zu den Lötkontakten. Insbesondere werden folgende Vorteile realisiert:
a) Die in der IBC-Zelle verwendete Fingerstruktur der Metallisierung wird verlassen, und somit ist die begrenzte Minimierung der Fingerbreite und damit des Pitches (Abstand Fingerzentrum zu Fingerzentrum) aufgehoben;
b) Die Anbindung aller Emitterkontakte und der Basiskontakte in einer Einheitszelle an ihren jeweiligen zentralen Lötpunkt wird über jeweils nur ein einziges metallisches Quadrat (ein Square) erreicht; damit ist die Notwendigkeit einer dicken (Siebdruck-)Metallisierung aufgehoben; es kann Dünnschichttechnik eingesetzt werden.
c) Die Isolation zwischen der Emittermetallisierung und der Basismetallisierung wird sowohl vertikal als auch lateral durch großflächige Dünnfilmisolierschichten schon während der Prozessierung eingebaut, die für die Spannungsklasse von Solarzellen (typisch <5V) vollkommen ausreichend isolieren. Somit sind keine laserbasierten Prozesse zur Kantenisolation und zur Trennung der Basis- und Emitterkontakte notwendig.
d) Die Anzahl, Größe und Anordnung der Lötkontakte und somit die Geometrie der Verbindungselemente bei der Modulintegration können vollkommen frei gewählt werden, ohne dass die erfindungsgemäße Solarzellenmetallisierung selbst in irgendeiner Weise dabei verändert wird, weil die Mikrozellen- und Einheitszellenstrukturen für die gesamte Fläche invariant gegen die Auslegung der Lötpunkte, d.h. ihre Form, Größe und Position, sind.

Der Prozess für die Herstellung der Multilayerkontakt-Schichtfolge ist einfach strukturiert: er enthält in linearer Abfolge Dünnschichtabscheidungen und RIE-Ätzschritte. Eine Besonderheit ist die Strukturierung der Dielektrika und der Metallschichten durch Schattenmasken in den Ätzkammern. Dadurch müssen die Wafer nicht aus der Vakuumanlage ausgebaut, umgehordet, geätzt und wieder eingebaut werden. Stattdessen verbleiben sie während der gesamten Prozessfolge im Vakuum in den Kammern.

Da die Wafer von Prozessschritt zu Prozessschritt in ihrer einmal eingenommenen Position im Waferträger bleiben, gibt es kein Justage-/Alignment-Problem zwischen den Strukturen in den einzelnen Schichten. Erst der letzte Schritt einer bevorzugten Ausführung, das Sputtern einer lötfähigen Metallschicht (Layer 6) wird in einer separaten (kleineren) Sputteranlage ausgeführt, denn dazu wird vorteilhaft eine Schattenmaske mit Löchern an den Positionen der Lötkontaktflächen verwendet. Hier ist aber die Justage bzgl. der Öffnungen in den bereits vorliegenden Kontakt-Schichtstrukturen völlig unkritisch.

In einer Ausführung der Erfindung ist vorgesehen, dass auf der zweiten Metallschicht eine zweite Isolierschicht vollflächig und über diese eine Lötkontakt-Metallschicht lokal abgeschieden ist. Das ist insbesondere so ausgestaltet, dass die Lötkontakt-Metallschicht in miteinander ausgerichteten Durchbrüchen in der zweiten Isolierschicht, der zweiten Metallschicht und der ersten Isolierschicht die erste Metallschicht kontaktiert und in Durchbrüchen der zweiten Isolierschicht die zweite Metallschicht kontaktiert, wodurch Emitter- bzw. Basis-Lötkontaktbereiche gebildet sind.

In einer bevorzugten geometrischen Konfiguration ist mindestens ein Teil der Basisbereiche von Emitterbereichen umschlossen, die einen wesentlich höheren Flächenanteil der Hauptoberfläche einnehmen als die Basisbereiche.

Bei der technologischen Ausgestaltung der Erfindung wird zweckmäßigerweise eine Reihe von Bemessungsregeln für die Durchbrüche in den verschiedenen Schichten beachtet. Speziell haben im Bereich der Emitter-Lötkontakte die Durchbrüche in der ersten und der zweiten Isolierschicht eine kleinere Weite als die Durchbrüche in der zweiten Metallschicht, aber eine größere Weite als die Durchbrüche in der Passivierungsschicht. Des Weiteren haben im Bereich der Basis-Lötkontakte die Durchbrüche in der ersten Isolierschicht eine kleinere oder die gleiche Weite wie diejenigen der zweiten Isolierschicht und beide eine kleinere Weite als die Durchbrüche in der zweiten Metallschicht. Schließlich ist zweckmäßigerweise vorgesehen, dass die Durchbrüche in der ersten Isolierschicht über den Basisbereichen eine größere Weite als die Durchbrüche in der Passivierschicht haben.

Aus derzeitiger Sicht weiter bevorzugt ist es, wenn die erste Metallschicht in Randbereichen eines Wafer-Substrates längliche, voneinander beabstandete Aussparungen aufweist, wobei der Abstand kleiner als die Länge der Aussparungen ist, die erste Isolierschicht sich bis zum Rand des Wafer-Substrates erstreckt und die zweite Metallschicht ebenfalls längliche Aussparungen in Randbereichen des Wafer-Substrates aufweist, welche insbesondere über den bis zum Rand des Wafer-Substrates reichenden Bereichen der ersten Metallschicht liegen, wobei bis zum Rand reichende Bereiche der zweiten Metallschicht über den Aussparungen der ersten Metallschicht liegen.

Weiterhin ist die Erfindung zweckmäßig dahingehend ausgestaltet, dass die erste und/oder zweite Metallschicht überwiegend aus Nickel oder Aluminium bestehen. Grundsätzlich sind aber auch andere Metalle für die Ausführung der Metallschichten einsetzbar, die sich in die Halbleitertechnologie für Kontaktstrukturen bewährt haben und ggf. bestimmte Anforderungen besser erfüllen als Aluminium.

Eine weitere Ausgestaltung der Erfindung sieht vor, dass die Emitter- und Basis-Lötkontaktbereiche eine erste und zweite, insbesondere jeweils quadratische, Matrix über der Hauptoberfläche bilden, die insbesondere um jeweils ½ Pitch in x- und γ-Richtung gegenüber verschoben sind.

Bei dem erfindungsgemäßen Verfahren sind die Abscheidungsschritte für die einzelnen Schichten, speziell die erste und zweiten Metallschicht und die erste und die optional vorgesehene zweite Isolierschicht, als Vakuum- oder Gasphasen-Abscheidungsverfahren, insbesondere Vakuum-Bedampfungsverfahren oder Sputterverfahren, ausgestaltet. Zweckmäßigerweise werden die Durchbrüche in der Passivierungsschicht und in der ersten und wahlweise zweiten Isolierschicht und/oder die Durchbrüche in der ersten und zweiten Metallschicht durch ein Trockenätzverfahren, insbesondere reaktives Ionenätzen, unter Einsatz einer metallischen Schattenmaske gebildet. Die spätere Bildung der Ermitter- und Basislötkontakte erfolgt in vorteilhafter Weise simultan ebenfalls durch einen Bedampfungs- oder Sputterschritt, im Gegensatz zu den vorgenannten Verfahrensschritten aber nicht vollflächig über das gesamte Substrat, sondern unter Einsatz einer geeigneten Maske lediglich lokal begrenzt.

Vorteile und Zweckmäßigkeiten der Erfindung ergeben sich im Übrigen aus der nachfolgenden Beschreibung anhand der Figuren. Von diesen zeigen:
- Fig. 1: eine schematische Darstellung der Kontaktstruktur einer bekannten Solarzelle, der sogenannten IBC-Zelle,
- Fig. 2: eine schematische Darstellung (Draufsicht) der Kontaktstruktur einer erfindungsgemäßen Solarzelle,
- Fig. 3 und 3A: die Einheitszelle als Ausschnitt aus Fig. 2 in Draufsicht, bestehend aus vielen Mikrozellen (schematisch), als Ausschnitt aus Fig. 3,
- Fig. 4A und 4B: eine Draufsicht bzw. eine schematische Querschnittsdarstellung der sogenannten Mikrozelle einer erfindungsgemäßen Kontaktstruktur, als Ausschnitt aus Fig. 3,
- Fig. 5A und 5B: in schematischer Darstellung die Schichtfolge eines lokalen Basis-BSF-Lötkontaktes (Fig. 5A) bzw. eines lokalen Emitter-Lötkontaktes (Fig. 5B),
- Fig. 6A bis 6D: schematische Draufsichten bzw. Querschnittsdarstellungen des Teilbereiches Emitterlötkontakt, und zwar Fig. 6A und 6B einen Schnitt der Emitterkontakte und Fig. 6C und 6D einen Schnitt der BSF-Kontakte,
- Fig. 7A bis 7F: schematische Draufsichten bzw. Querschnittsdarstellungen dreier Rand-Teilbereiche der Kontaktstruktur, und zwar Fig. 7A und 7B einen Schnitt der Emitterkontakte in einem Teilbereich 1, Fig. 7C und 7D einen Schnitt der BSF-Kontakte in einem Teilbereich 2 und Fig. 7E und 7F einen Schnitt der BSF-Kontakte in einem Teilbereich 3.

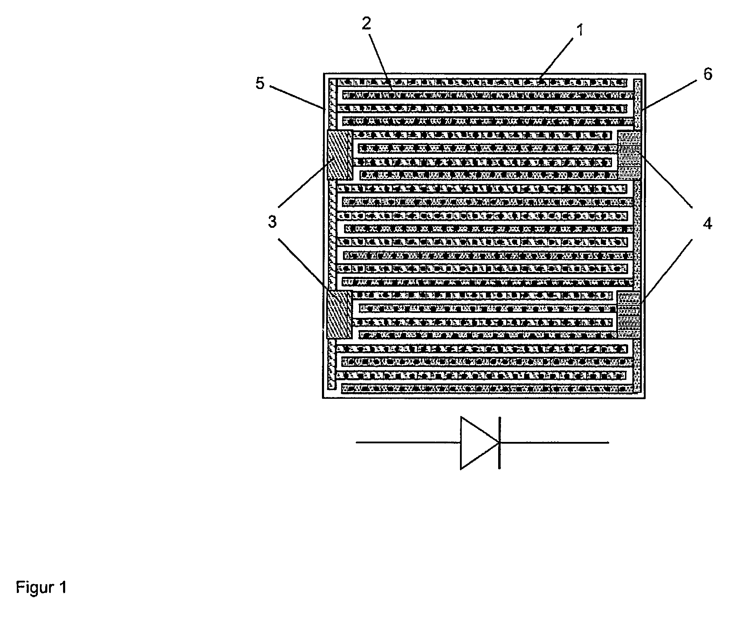

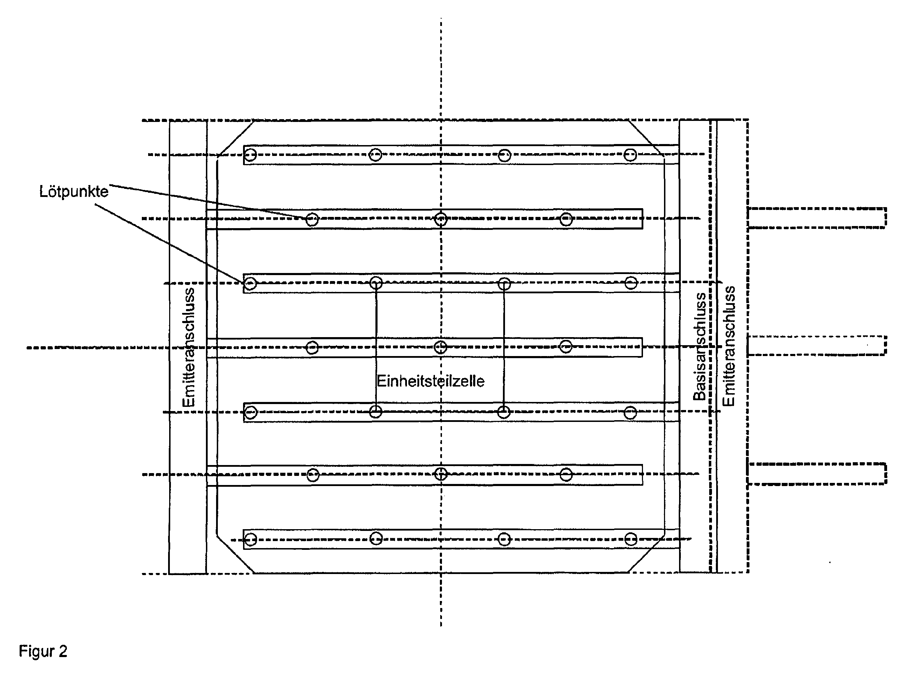

Fig. 1 zeigt eine als solche bekannte Kontaktstruktur einer IBC-Zelle, die einen Metallkontaktkamm 1 für die erste Polarität, einen Metallkontaktkamm 2 für die zweite Polarität, Lötkontaktflächen 3 für die erste Polarität, Lötkontaktflächen 4 für die zweite Polarität, einen Busbar 5 für die erste Polarität und einen Busbar 6 für die zweite Polarität umfasst.
Die Erfindung wird anhand der schematischen Darstellungen in den Figuren 2 bis 7 näher beschrieben. Ausgangsmaterial ist ein Silizium-Wafer in Quadrat-, Pseudoquadrat- oder auch Kreisform. In den Figuren ist als typisches Beispiel jeweils die Pseudoquadratform gezeigt.

### 1. Merkmal Multilayer Back Contacts

Die erfindungsgemäße Metallisierungsmethode ist für Solarzellenstrukturen mit rückseitigen Emitter- und Basisstrukturen geeignet, wobei letztere entweder als schmale Streifen oder, vorzugsweise, als inselförmige kleine BSF-Punkte in einem großflächigen, sie umgebenden Emitterbereich ausgebildet sind. In beiden Fallen wird die erfindungsgemäße Basis- und Emittermetallisierung nicht als Fingerstruktur wie bei der in Figur 1 gezeigten IBC-Zelle geformt, sondern als Sandwich aus zwei vielfach durchlöcherten, aber vollflächigen, durch eine Isolationsschicht von einander isolierte Metallschichten ausgebildet.

Für ihren Aufbau auf der bereits abgeschiedenen rückseitigen Oberflächenpassivierschicht (Layer 1) werden folgende Funktionsschichten aufeinander abgeschieden.
Layer 2: Emitterkontakt-Metallschicht (vollflächig)
Layer 3: Emitter-Basis-Isolationsschicht (vollflächig)
Layer 4: Basis-(BSF-)Kontakt-Metallschicht (vollflächig)
Layer 5: Oberflächen-Isolationsschicht (vollflächig)
Layer 6: Lötkontaktmetallschicht (lokal)

### 2. Merkmal Lötkontaktanordnung

Die erfindungsgemäße Solarzellenmetallisierung weist als Kontakte zu einem aufzulötenden oder aufzuklebenden Zellverbinder nur relativ wenige, auf den Kreuzungspunkten eines gedachten quadratischen Gitters angeordnete Lötpunkte mit einem Abstand von z.B. jeweils 44mm in x-Richtung und in γ-Richtung (Fig. 2) auf. Die Abstande und somit die Zahl der Zellenverbinderstrange können aber auch anders dimensioniert oder auch in x- und γ-Richtung verschieden groß gewählt werden; die Kontakte konnten sogar beliebig (regelmäßig oder unregelmäßig) angeordnet sein.

### 3. Merkmal Rotationssymmetrie

In der gezeigten, bevorzugt regelmäßigen Ausführungsform ist die Zelle um n*90° rotationssymmetrisch.

### 4. Merkmal Einheitszellen bestehend aus "Mikrozellen"

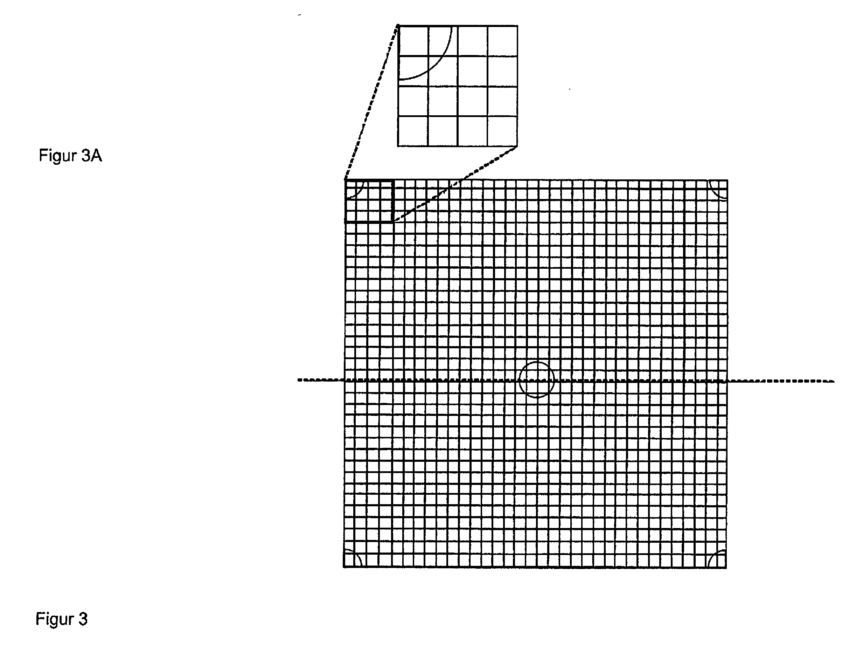

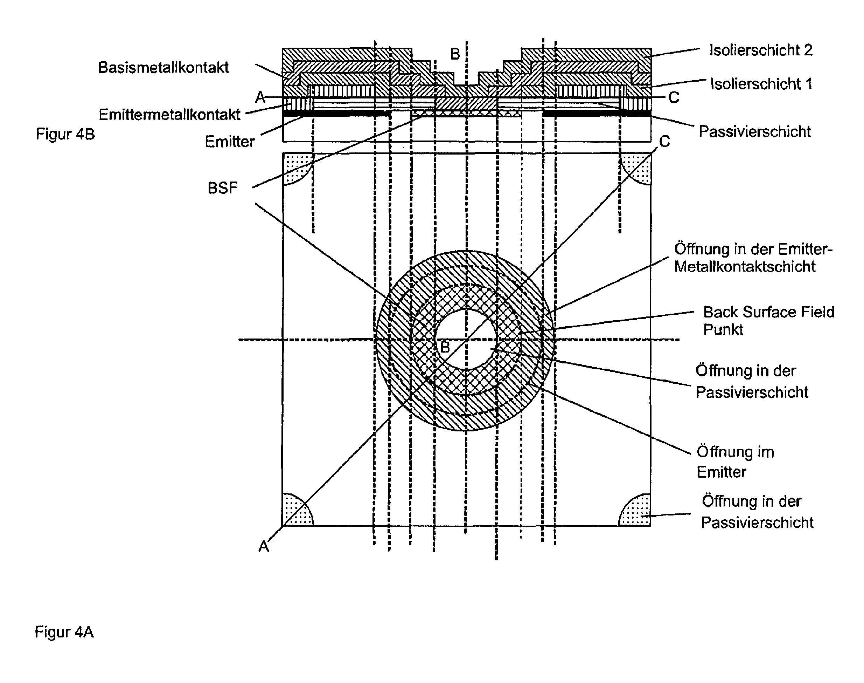

Der Bereich zwischen jeweils vier beispielsweise im Quadrat angeordneten Lötkontaktpunkten kann als "Einheitszelle" definiert werden (Figur 3), die, in beiden Richtungen vielfach aneinander gesetzt, die gesamte Waferoberfläche abdeckt. Sie besitzt im Zentrum einen Lötpunkt (mit z.B. Ø 4,2mm) für die Basis und 4 Viertel-Lötpunkte in den Ecken für den Emitter und besteht im gewählten Beispiel aus 44 x 44 "Mikrozellen" der Dimension (z.B.) 1mm x 1mm (Fig. 4A).

### 5. Merkmal Mikrozellenstruktur

Die Mikrozellen bedecken somit die gesamte Solarzelle, bis auf einen Randbereich von z.B. 1mm Breite. Ihre Form und Dimensionen sind prinzipiell frei wählbar. Sie besitzen im Zentrum einen Kontaktpunkt zum streifen- oder punktförmigen Basis- bzw. BSF-Dotierbereich (Fig. 4A), wahrend in den Ecken die Emitteroberfläche kontaktiert wird. Die Entfernung eines Punktes in der Mikrozelle bis zum Rand dieses zentralen Basispunktes (d.h. etwa die Diagonale der Mikrozelle) darf maximal die Größe der mittleren Diffusionslänge der Minoritätsladungsträger haben und muss somit abhängig von der Lebensdauer im gewählten Wafermaterial ausgelegt werden.

Fig. 4B zeigt, wie in diesem Kontaktbereich das BSF im Halbleiter mit dem Layer 4, der Basismetallkontaktschicht, in Verbindung steht.

Die Emitterdotierung füllt die Fläche der Mikrozelle fast vollflächig aus, bis auf einen zentralen schmalen Streifen (nicht gezeichnet) oder einen inselförmigen Bereich, der quadratisch oder, vorzugsweise, rund mit einem Durchmesser von z.B. Ø 500µm ausgebildet ist und der (unter Berücksichtigung eines minimalen lateralen Abstands, z.B. 75um), den BSF-Bereich (z.B. Ø 350µm) aufnimmt (Fig. 4A). In diesem Beispiel ergeben sich für die Mikrozelle und damit auch für die gesamte Solarzelle, eine Emitterüberdeckung von 80,4% und eine BSF-Überdeckung von 9,6%. Die restlichen 10% werden als Isolierstreifen zwischen Emitter und BSF basisdotiert gelassen.

Die Passivierschicht (Layer 1) besitzt einen Durchbruch mit einem kleineren Durchmesser (z.B. Ø 200µm) als dem des BSF-Bereichs (z.B. Ø 350µm), die Emitter-Metallkontaktschicht (Layer 2) besitzt einen Durchbruch mit deutlich größerem Durchmesser (z.B. Ø 600µm), und Layer 3, die Isolierschicht 1 zwischen Emitter-Metallkontaktschicht (Layer 2) und BasisMetallkontaktschicht (Layer 4), besitzt wieder einen Durchbruch mit kleinerem Durchmesser, der also z.B. genauso groß ist wie der in der Passivierschicht (z.B. Ø 200µm). Auf diese Weise taucht die obere Metallschicht (Layer 4) stufenweise bis hinunter auf die Halbleiteroberfläche und kontaktiert den BSF-Bereich auf der in der Passivierschicht freigelegten Fläche, ohne die Emittermetallisierung (Layer 2) zu berühren.

### 6. Merkmal Lötkontaktdesign

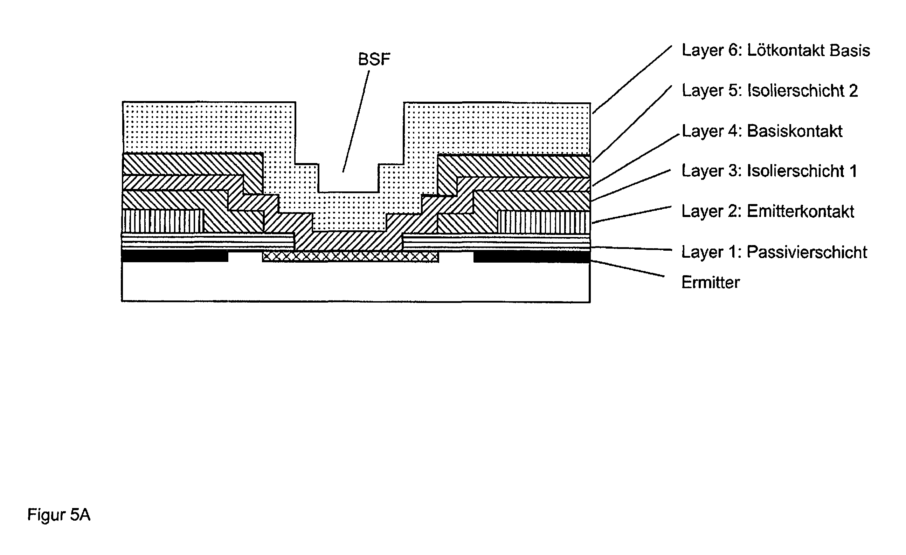

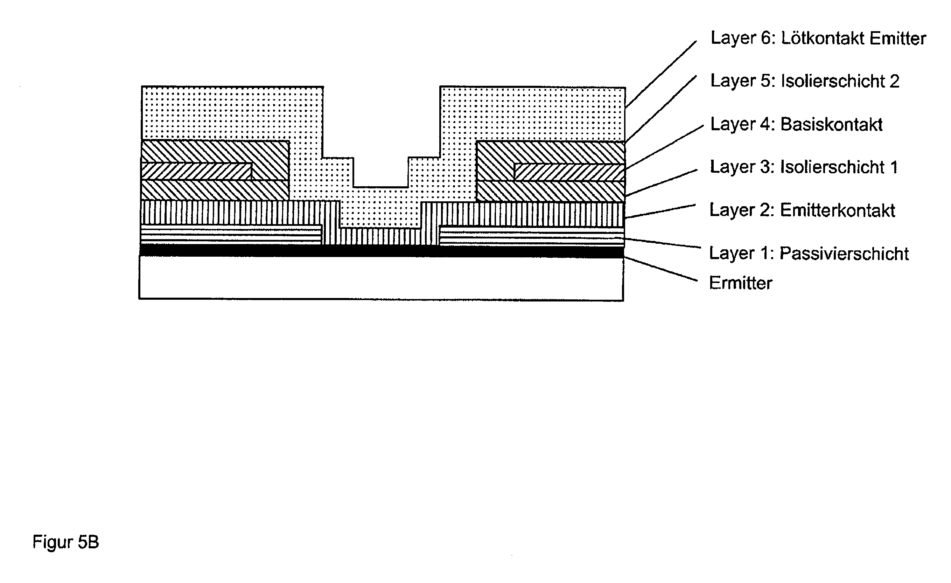

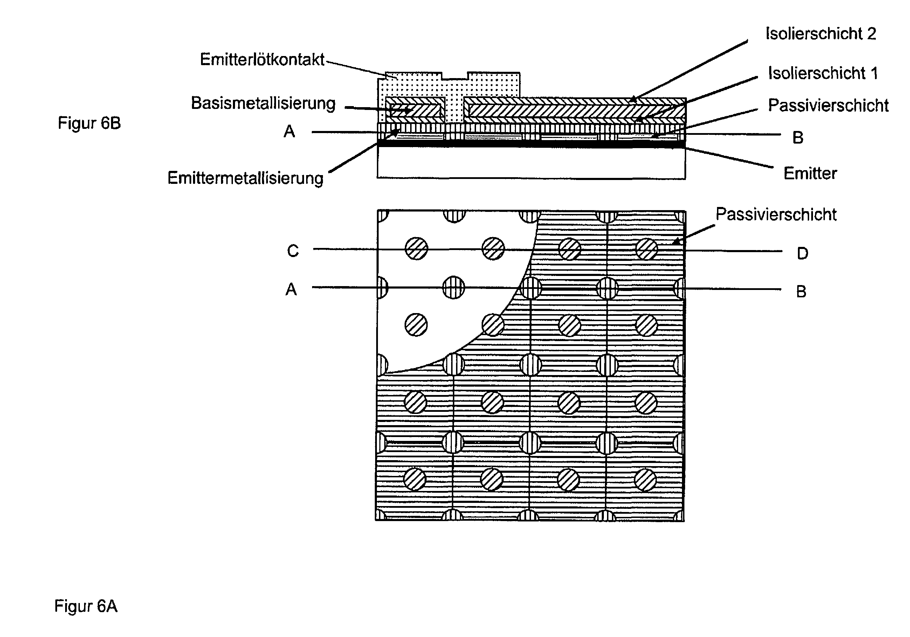

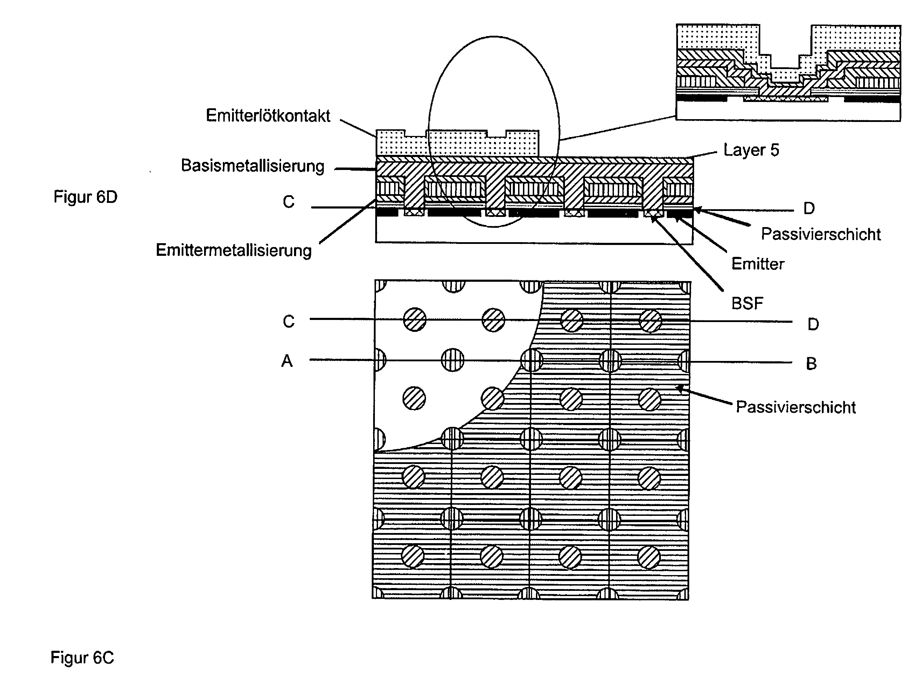

Unter den Lötkontakten muss das Design an die Polarität des jeweiligen Lötkontakts angepasst werden. In Fig. 5A und 5B sind beispielhaft und schematisch zwei Querschnitte durch einen Basis-Lötkontakt bzw. EmitterLötkontakt gezeichnet, bei denen die Lötkontaktmetallschicht (Layer 6) die jeweilige Metallschicht im Bereich des "richtigen" Dotierbereichs kontaktiert. In Fig. 6B (Schnitt A-B) ist noch einmal etwas schematischer im Querschnitt und zusammen mit der Draufsicht auf den Lötkontakt gezeigt, wie dieser die darunter liegenden "richtigen" lokal freigelegten Bereiche des Emitters kontaktiert, wahrend Figur 6D (Schnitt C-D) zeigt, dass er lokale Bereiche der "falschen" Polarität (also die BSF-Oberfläche) nicht kontaktiert, sondern auf der obersten Isolationsschicht (Layer 5) verbleibt.

### 7. Merkmal Randstruktur

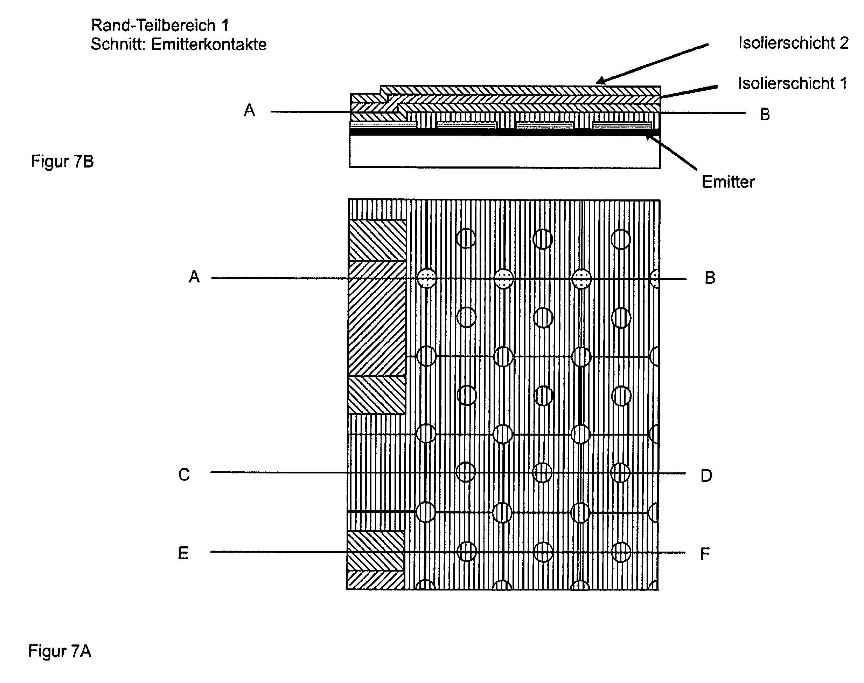

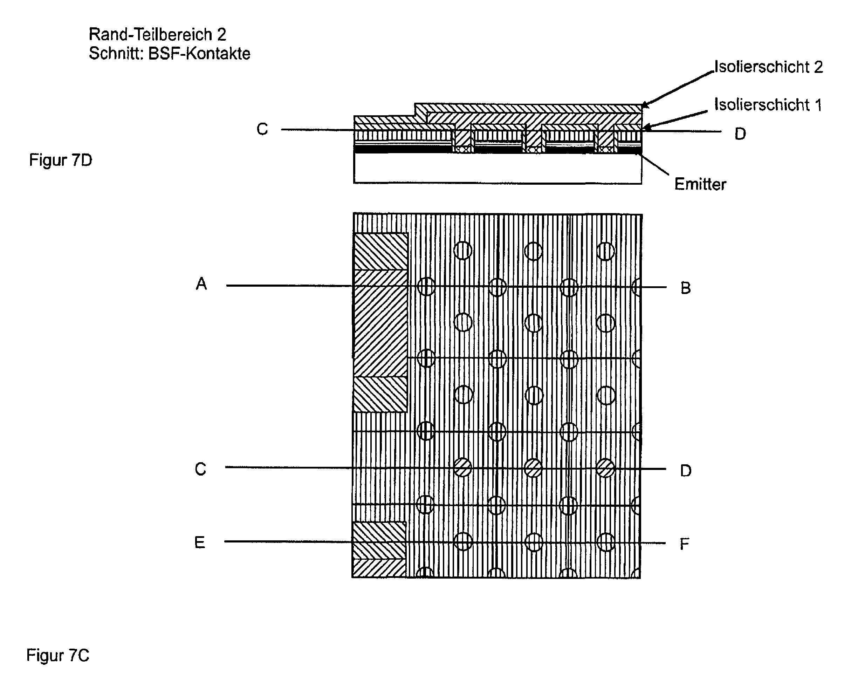

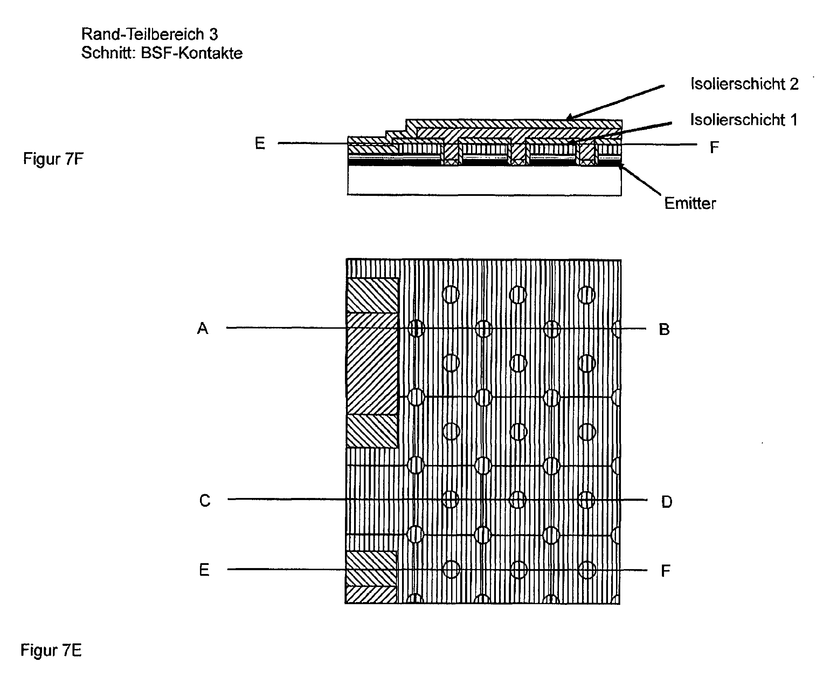

Da die Metallschichten jeweils vollflächig aufgebracht werden, könnten sie sich am Rand des Wafers berühren und die n- und p-Gebiete kurzschließen. Aus diesem Grund wird eine überlappende Zahnstruktur vorgeschlagen (Fig. 7), die die Isolation der Metallschichten sicherstellt. In den Teilfiguren 7B, 7D und 7F sind Schnitte an 3 verschiedenen Stellen gezeigt, die die Ausdehnungen von Metall- und Isolationsschichten beispielhaft skizzieren. Die Metallschichten treffen an verschiedenen Stellen auf den Waferrand, indem sie in den jeweils komplementären Bereichen nach der Abscheidung gleich wieder entfernt werden, bevor die nächste Schicht aufgebracht wird.

### Prozessfolge zur Herstellung der MBC-Zelle

Die erfindungsgemäße Prozessfolge für die Metallisierung wird in einer Durchlauf-Vakuumanlage mit mehreren Sputter- oder Aufdampfkammern und Trockenätzkammern durchgeführt. Dabei wird die Strukturierung (lokale Entfernung) der Schichten zum Beispiel durch Plasmaätzen, z.B. reaktives lonenätzen, durch eine Schattenmaske hindurch erreicht. Für Dielektrika (Layer 1 & 3 & 5) werden fluor-basierte Ätzgase (z.B. SF₆, CHF₃, CH₄) eingesetzt, für die aluminiumhaltigen Metallschichten (Layer 2 & 4) werden dagegen chlorhaltige Ätzgase benötigt (z.B. BCl₃+Cl₂). Nur die letzte Schicht, die Lötpadmetallschicht (Layer 6) wird vorteilhaft mittels einer Schattenmaske strukturiert aufgesputtert oder aufgedampft und optional mit einem galvanischen oder chemischen Abscheidungsverfahren in ihrer Schichtdicke verstärkt.

## Patentansprüche

1. Solarzelle mit einem Halbleitersubstrat, in dessen einer Hauptoberfläche zueinander benachbart Emitterbereiche und hochdotierte Basisbereiche vorgesehen sind, und einer auf dieser Hauptoberfläche angeordneten Passivierungsschicht (layer 1), welche Durchbrüche zur lokalen Kontaktierung der Emitterbereiche mit einer ersten Metallschicht (layer 2) und der Basisbereiche mit einer zweiten Metallschicht (layer 4) aufweist, wobei die erste Metallsclicht (layer 2) aus einer vollflächig über dem Halbleitersubstrat abgeschiedenen Dünnschicht besteht, die die Emitterbereiche in den Durchbrüchen in der Passivierschicht lokal kontaktiert und die über den Basisbereichen Ausnshmungen hat, über der ersten Metallschicht (layer 2) eine erste Isolierschicht (layer 3) abgeschieden ist, die ebenfalls Ausnehmungen über den Basisbereichen hat, und über der ersten Isolierschicht (layer 3) somit von der ersten Metallschicht (layer 2) elektrischt isoliert eine zweite Metallschicht (layer 4) derat abgeschieden ist, dass sie sich in die Ausnehmungen der ersten Metallschicht (layer 2) und der Isolierschicht (layer 3) hinein erstreckt und die Hauptoberfläche in den Basisbereichen kontaktiert,
**dadurch gekennzeichnet,**
**dass** die zweite Metallschicht (layer 4) stufenweise durch unterschiedlich große weiter der Durchbrüche darunterliegender Schichten bis zum Basisbereich verläuft.

2. Solarzelle nach Anspruch 1, wobei auf der zweiten Metallschicht (layer 4) eine zweite Isolierschicht vollflächig (layer 5) und über diese eine Lötkontakt-Metallschicht (layer 6) lokal abgeschieden ist.

3. Solarzelle nach Anspruch 2, wobei die Lötkontakt-Metallschicht (layer 6) in zueinander ausgerichteten Durchbrüchen in der zweiten Isolierschicht (layer 5) der zweiten Metallschicht (layer 4) und der ersten Isolierschicht (layer 3) die erste Metallschicht (layer 2) kontaktier und, an anderer Stelle, in Durchbrüchen der zweiten Isolierschicht (layer 5) die zweite Metallschicht (layer 4) kontaktiert, wodurch Emitter- bzw. Basis-Lötkontaktbereiche gebildet sind.

4. Solarzelle nach einem der vorangehenden Ansprüche, wobei die Basisbereiche einen kleineren Flächenanteil der Hauptoberfläche einnehmen als die Emitterbereiche.

5. Solarzelle nach Anspruch 3 oder 4, wobei im Bereich der Emitter-Lötkontakte die Durchbrüche in der ersten und der zweiten Isolierschicht (layer 3, layer 5) eine kleinere Weite als die Durchbrüche in der zweiten Metallschicht (layer 4), aber eine größere Weite als die Durchbrüche in der Passivierungsschicht (layer 1) haben.

6. Solarzelle nach einem der Ansprüche 3 - 5, wobei im Bereich der Basis-Lötkontakte die Durchbrüche in der ersten Isolierschicht (layer 3) kleinere oder die gleiche Weite wie diejenigen der zweiten Isolierschicht (layer 5) und beide eine kleinere Weite als die Durchbrüche in der zweiten Metallschicht (layer 4) haben.

7. Solarzelle nach einem der vorangehende Ansprüche, wobei die Durchbrüche in der ersten Isolierschicht (layer 3) uber den Basisbereichen eine größere Weite als die Durchbrüche in der Passivierschicht (layer 1) haben.

8. Solarzelle nach einem der vorangehenden Ansprüche, wobei die erste Metallschicht in Randbereichen eines Wafer-Substrates längliche, voneinander beabstandete Aussparungen aufweist, wobei der Abstand kleiner als die Länge der Aussparungen ist, die erste Isolierschicht (layer 3) sich bis zum Rand des Wafer-Substrates erstreckt und die zweite Metallschicht (layer 4) ebenfalls längliche Aussparungen in Randbereichen des Wafer-Substrates aufweist, welche insbesondere über den bis zum Rand des Wafer-Substrates reichenden Bereichen der ersten Metallschicht liegen (layer 2) wobei bis zum Rand reichende Bereiche der zweiten Metallschicht (layer 4) über den Aussparungen der ersten Metallschicht (layer 2) liegen.

9. Solarzelle nach einem der vorangehenden Ansprüche, wobei die erste und/oder zweite Metallschicht (layer 2, layer 4) überwiegend aus Nickel oderAluminium bestehen.

10. Solarzelle nach einem der Ansprüche 3 bis 9, wobei die Emitter- und Basis-Lötkontaktbereiche eine erste und zweite, insbesondere jeweils quadratische, Matrix über der Hauptoberfläche bilden, die insbesondere um jeweils ½ Pitch in x- und y-Richtung gegenüber verschoben sind.

11. Verfahren zur Herstellung einer Solarzelle nach einem der vorangehenden Ansprüche, wobei die erste und zweite Metallschicht (layer 2, layer 4) und die erste Isolierschicht (layer 3) durch ein Vakuum- oder Gasphasen-Abscheidungsverfahren, insbesondere Aufdampfen oder Sputtern, gebildet werden.

12. Verfahren nach Anspruch 11, wobei die Durchbrüche in der Passivierungsschicht (layer 1) und in der ersten und wahlweise zweiten Isolierschicht (layer 3, layer 5) und/oder die Durchbrüche in der ersten und zweiten Metallschicht (layer 2, layer 4) durch ein Trockenätzverfahren, insbesondere reaktives Ionenätzen, unter Einsatz einer metallischen Schattenmaske gebildet werden.

13. Verfahren nach Anspruch 11 oder 12, wobei alle Emitter- und Basislötkontakte auf einem Substrat simultan durch Aufdampfen oder Sputtern einer Metallschichtfolge durch eine metallische Schattenmaske hindurch gebildet werden die mit einem chemischen oder galvanischen Verfahren verstärkt werden.

14. Verfahren nach einem der Ansprüche 11 - 13, wobei
a) die Passivierschicht (layer 1) in den Emitterbereichen und den Basisbereichen mit Durchbrüchen versehen wird,
b) die erste Metallschicht (layer 2) über den Substrat vollflächig abgeschieden wird,
c) die erste Metallschicht (layer 2) über den Basisbereichen und den Durchbrüchen in der Passivierschicht (layer 1) mit Durchbrüchen versehen wird, welche größer als die Durchbrüche in der Passivierschicht (layer 1) sind, und in Randbereichen des Wafer-Substrates am Rand der ersten Metallschicht (layer 2) längliche Aussparungen erzeugt werden deren Länge größer als ihr Abstand ist,
d) auf der ersten Metallschicht (layer 2) eine erste Isolierschicht (layer 3) vollflächig abgeschieden wird,
e) die erste Isolierschicht (layer 3) uber den Emitter- bzw. Basisbereichen mit Durchbrüchen am Ort später vorzusehende Lötkontakte versehen wird,
f) auf die erste Isolierschicht (layer 3) eine zweite Metallschicht (layer 4) vollflächig abgeschieden wird,
g) die zweite Metallschicht (layer 4) im Bereich der späteren Emitterlötkontaktpunkte über den entsprechenden Durchbrüchen der Passivierschicht und denen in der ersten Isolierschicht (layer 3) mit Durchbrüchen versehen wird, die größer als jene sind, und in Randbereichen des Wafer-Substrates am Rand der zweiten Metallschicht (layer 4) dort längliche Aussparungen erzeugt werden, wo die erste Metallschicht (layer 2) bis zum Rand reicht, während die zweite Metallschicht (layer 4) bis zum Rand reicht, wo unter ihr Aussparungen in der ersten Metallschicht (layer 2) vorgesehen sind,
h) auf die zweite Metallschicht (layer 4) eine zweite Isolierschicht (layer 5) vollflächig abgeschieden wird,
i) die zweite Isolierschicht (layer 5) über den Emitter- und Basisbereichen am Ort der späteren Lötkontakte über den Durchbrüchen in der ersten bzw. zweiten Metallschicht (layer 2, 4) mit Durchbrüchen versehen wird, die kleiner als jene sind,
j) eine Lötkontakt-Metallschicht aus lötfähigem oder chemisch oder galvanisch verstärkbarem Material lokal am Ort der späteren Lötkontakte, nämlich derart, dass sie am Ort von Emitterlötpunkten die erste Metallschicht (layer 2) kontaktiert und am Ort von Basislötpunkten die zweite Metallschicht (layer 4) kontaktiert, abgeschieden wird,

## Claims

1. Solar cell comprising a semiconductor substrate, in one main surface of which emitter regions and highly doped base regions are provided adjacent to one another, and comprising a passivation layer (layer 1) arranged on said main surface, said passivation layer having perforations for locally making contact between the emitter regions and a first metal layer (layer 2) and between the base regions and a second metal layer (layer 4), wherein the first metal layer (layer 2) consists of a thin layer which is deposited over the whole area over the semiconductor substrate and which locally makes contact with the emitter regions in the perforations in the passivation layer and which has cutouts above the base regions, a first insulating layer (layer 3) is deposited over the first metal layer (layer 2), said first insulating layer likewise having cutouts above the base regions, and a second metal layer (layer 4) is deposited over the first insulating layer (layer 3) and thus in a manner electrically insulated from the first metal layer (layer 2) in such a way that said second metal layer extends into the cutouts of the first metal layer (layer 2) and of the insulating layer (layer 3) and makes contact with the main surface in the base regions,
**characterized in that** the second metal layer (layer 4) runs in a stepwise manner through widths of different magnitudes of the perforations of underlying layers as far as the base region.

2. Solar cell according to Claim 1, wherein a second insulating layer (layer 5) is deposited over the whole area on the second metal layer (layer 4) and a soldering contact metal layer (layer 6) is deposited locally over said second insulating layer.

3. Solar cell according to Claim 2, wherein the soldering contact metal layer (layer 6) makes contact with the first metal layer (layer 2) in perforations aligned with one another in the second insulating layer (layer 5), the second metal layer (layer 4) and the first insulating layer (layer 3) and makes contact with the second metal layer (layer 4) elsewhere, in perforations of the second insulating layer (layer 5), as a result of which emitter and base soldering contact regions, respectively, are formed.

4. Solar cell according to any of the preceding claims, wherein the base regions take up a smaller area proportion of the main surface than the emitter regions.

5. Solar cell according to Claim 3 or 4, wherein, in the region of the emitter soldering contacts, the perforations in the first and the second insulating layers (layer 3, layer 5) have a smaller width than the perforations in the second metal layer (layer 4), but a larger width than the perforations in the passivation layer (layer 1).

6. Solar cell according to any of Claims 3-5, wherein, in the region of the base soldering contacts, the perforations in the first insulating layer (layer 3) have a smaller width than or the same width as the perforations of the second insulating layer (layer 5) and both have a smaller width than the perforations in the second metal layer (layer 4).

7. Solar cell according to any of the preceding claims, wherein the perforations in the first insulating layer (layer 3) above the base regions have a larger width than the perforations in the passivation layer (layer 1).

8. Solar cell according to any of the preceding claims, wherein the first metal layer has elongate recesses situated at a distance from one another in edge regions of a wafer substrate, wherein the distance is less than the length of the recesses, the first insulating layer (layer 3) extends as far as the edge of the wafer substrate, and the second metal layer (layer 4) likewise has elongate recesses in edge regions of the wafer substrate, which lie in particular above those regions of the first metal layer (layer 2) which reach as far as the edge of the wafer substrate, wherein regions of the second metal layer (layer 4) which reach as far as the edge lie above the recesses of the first metal layer (layer 2).

9. Solar cell according to any of the preceding claims, wherein the first and/or second metal layer (layer 2, layer 4) predominantly consist(s) of nickel or aluminium.

10. Solar cell according to any of Claims 3 to 9, wherein the emitter and base soldering contact regions form a first and second, in particular in each case square, matrix above the main surface, which are displaced relative to one another in particular by in each case ½ pitch in the x- and y-directions.

11. Method for producing a solar cell according to any of the preceding claims, wherein the first and second metal layers (layer 2, layer 4) and the first insulating layer (layer 3) are formed by a vacuum or vapour deposition method, in particular vapour deposition or sputtering.

12. Method according to Claim 11, wherein the perforations in the passivation layer (layer 1) and in the first and optionally second insulating layer (layer 3, layer 5) and/or the perforations in the first and second metal layers (layer 2, layer 4) are formed by a dry etching method, in particular reactive ion etching, using a metallic shadow mask.

13. Method according to Claim 11 or 12, wherein all emitter and base soldering contacts on a substrate are formed simultaneously by vapour deposition or sputtering of a metal layer sequence through a metallic shadow mask, which are reinforced by a chemical or electrolytic method.

14. Method according to any of Claims 11-13, wherein
a) the passivation layer (layer 1) is provided with perforations in the emitter regions and the base regions,
b) the first metal layer (layer 2) is deposited over the whole area over the substrate,
c) the first metal layer (layer 2) is provided, above the base regions and the perforations in the passivation layer (layer 1), with perforations which are larger than the perforations in the passivation layer (layer 1), and elongate recesses whose length is greater than the distance between them are produced in edge regions of the wafer substrate at the edge of the first metal layer (layer 2),
d) a first insulating layer (layer 3) is deposited over the whole area on the first metal layer (layer 2),
e) the first insulating layer (layer 3) is provided, above the emitter and base regions, with perforations at the location of soldering contacts that are to be provided later,
f) a second metal layer (layer 4) is deposited over the whole area onto the first insulating layer (layer 3),
g) the second metal layer (layer 4) is provided, in the region of the later emitter soldering contact points above the corresponding perforations of the passivation layer and those in the first insulating layer (layer 3), with perforations that are wider than those, and elongate recesses are produced in edge regions of the wafer substrate at the edge of the second metal layer (layer 4) where the first metal layer (layer 2) reaches as far as the edge, while the second metal layer (layer 4) reaches as far as the edge where, below it, recesses are provided in the first metal layer (layer 2),
h) a second insulating layer (layer 5) is deposited over the whole area onto the second metal layer (layer 4),
i) the second insulating layer (layer 5) is provided, above the emitter and base regions at the location of the later soldering contacts above the perforations in the first and second metal layer (layer 2, 4), respectively, with perforations that are smaller than those,
j) a soldering contact metal layer composed of solderable or chemically or electrolytically reinforceable material is deposited locally at the location of the later soldering contacts, namely in such a way that it makes contact with the first metal layer (layer 2) at the location of emitter soldering points and makes contact with the second metal layer (layer 4) at the location of base soldering points.

## Revendications

1. Cellule solaire présentant
un substrat semi-conducteur dans la surface principale duquel des parties émettrices voisines de parties de base fortement dopées sont prévues,
une couche de passivation (couche 1) disposée sur cette surface principale et qui présente des perforations qui assurent le contact local des parties émettrices avec une première couche métallique (couche 2) et des parties de base avec une deuxième couche métallique (couche 4),
la première couche métallique (couche 2) étant constituée d'une mince couche déposée sur toute la surface du substrat semi-conducteur, en contact local avec les parties émettrices dans les perforations ménagées dans la couche de passivation et présentant des découpes qui s'étendent sur les parties de base,
une première couche isolante (couche 3) étant déposée au-dessus de la première couche métallique (couche 2) et présentant également des découpes au-dessus des parties de base, et une deuxième couche métallique (couche 4) étant déposée au-dessus de la première couche isolante (couche 3) et étant ainsi électriquement isolée de la première couche métallique (couche 2), de telle sorte qu'elle s'étende dans les découpes de la première couche métallique (couche 2) et de la couche isolante (couche 3) et qu'elle assure le contact avec la surface principale dans les parties de base,
**caractérisée en ce que**
la deuxième couche métallique (couche 4) s'étend en gradins jusqu'à la partie de base par des couches de différentes tailles sous-jacentes aux perforations.

2. Cellule solaire selon la revendication 1, dans laquelle une deuxième couche isolante (couche 5) est déposée sur toute la surface de la deuxième couche métallique (couche 4) et une couche métallique de contact brasée (couche 6) est déposée localement au-dessus de cette couche isolante.

3. Cellule solaire selon la revendication 2, dans laquelle la couche métallique de contact brasée (couche 6) assure le contact avec la première couche métallique (couche 2) dans des perforations orientées l'une vers l'autre et ménagées dans la deuxième couche isolante (couche 5), la deuxième couche métallique (couche 4) et la première couche isolante (couche 3) et, en d'autres emplacements, assure le contact avec la deuxième couche métallique (couche 4) dans des perforations ménagées dans la deuxième couche isolante (couche 5), ce qui forme des parties brasées de contact d'émetteur ou de base.

4. Cellule solaire selon l'une des revendications précédentes, dans laquelle des parties de base occupent une plus petite proportion de la surface principale que les parties émettrices.

5. Cellule solaire selon les revendications 3 ou 4, dans laquelle les perforations ménagées dans la première et dans la deuxième couche isolante (couche 3, couche 5) présentent au niveau des contacts brasés d'émetteur une plus petite taille que les perforations ménagées dans la deuxième couche métallique (couche 4) mais une plus grande taille que les perforations ménagées dans la couche de passivation (couche 1).

6. Cellule solaire selon l'une des revendications 3 à 5, dans laquelle au niveau des contacts brasés de base, les perforations ménagées dans la première couche isolante (couche 3) ont une plus petite taille ou la même taille que celles ménagées dans la deuxième couche isolante (couche 5), toutes deux ayant une taille plus petite que les perforations ménagées dans la deuxième couche métallique (couche 4).

7. Cellule solaire selon l'une des revendications précédentes, dans laquelle les perforations ménagées dans la première couche isolante (couche 3) présentent au-dessus des parties de base une plus grande largeur que les perforations ménagées dans la couche de passivation (couche 1).

8. Cellule solaire selon l'une des revendications précédentes, dans laquelle la première couche métallique présente dans les bordures d'un substrat en galette des découpes allongées disposées à une distance mutuelle inférieure à la longueur des découpes, la première couche isolante (couche 3) s'étendant jusqu'au bord du substrat en galette et la deuxième couche métallique (couche 4) présentant également dans les bordures du substrat en galette des découpes allongées situées en particulier au-dessus des parties de la première couche métallique (couche 2) qui s'étendent jusqu'au bord du substrat en galette, les parties de la deuxième couche métallique (couche 4) qui s'étendent jusqu'au bord étant situées au-dessus des découpes ménagées dans la première couche métallique (couche 2).

9. Cellule solaire selon l'une des revendications précédentes, dans laquelle la première et/ou la deuxième couche métallique (couche 2, couche 4) sont principalement constituées de nickel ou d'aluminium.

10. Cellule solaire selon l'une des revendications 3 à 9, dans laquelle les parties brasées de contact d'émetteur et de base forment sur la surface principale une première et une deuxième matrice, de préférence toutes deux carrées, les matrices étant en particulier décalées chacune d'un demi-pas dans la direction x et dans la direction y.

11. Procédé de fabrication d'une cellule solaire selon l'une des revendications précédentes, dans lequel la première et la deuxième couche métallique (couche 2, couche 4) et la première couche isolante (couche 3) sont formées par une opération de dépôt sous vide ou en phase gazeuse, en particulier par vaporisation ou par pulvérisation.

12. Procédé selon la revendication 11, dans lequel les perforations ménagées dans la couche de passivation (couche 1) et dans la première et sélectivement la deuxième couche isolante (couche 3, couche 5) et/ou les perforations ménagées dans la première et dans la deuxième couche métallique (couche 2, couche 4) sont formées par une opération de gravure à sec, en particulier par gravure par ions réactifs, en recourant à un masque métallique.

13. Procédé selon les revendications 11 ou 12, dans lequel tous les contacts brasés d'émetteur et de base sont formés simultanément sur un substrat par vaporisation ou pulvérisation d'une succession de couches métalliques à travers un masque métallique, et sont renforcés par une opération chimique ou galvanique.

14. Procédé selon l'une des revendications 11 à 13, dans lequel
a) la couche de passivation (couche 1) est dotée de perforations dans les parties émettrices et les parties de base,
b) la première couche métallique (couche 2) est déposée sur toute la surface du substrat,
c) la première couche métallique (couche 2) est dotée de perforations au-dessus des parties de base et des perforations ménagées dans la couche de passivation (couche 1), ces perforations étant plus grandes que les perforations ménagées dans la couche de passivation (couche 1), et des découpes allongées dont la longueur est supérieure à leur distance mutuelle sont formées dans les bordures du substrat en galette sur le bord de la première couche métallique (couche 2),
d) une première couche isolante (couche 3) est déposée sur toute la surface la première couche métallique (couche 2),
e) au-dessus des parties émettrices et des parties de base, la première couche isolante (couche 3) est dotée de perforations à l'emplacement où des contacts brasés seront prévus ultérieurement,
f) une deuxième couche métallique (couche 4) est déposée sur toute la surface de la première couche isolante (couche 3),
g) au niveau des points ultérieurs de contact brasés d'émetteur, la deuxième couche métallique (couche 4) est dotée au-dessus des perforations correspondantes de la couche de passivation et de celles de la première couche isolante (couche 3) de perforations plus grandes que les premières, des découpes allongées étant formées dans les bordures du substrat en galette sur le bord de la deuxième couche métallique (couche 4) aux emplacements où la première couche métallique (couche 2) s'étend jusqu'au bord, tandis que la deuxième couche métallique (couche 4) s'étend jusqu'au bord là où des découpes sont prévues par dessous dans la première couche métallique (couche 2),
h) une deuxième couche isolante (couche 5) est déposée sur toute la surface de la deuxième couche métallique (couche 4),
i) la deuxième couche isolante (couche 5) est dotée au-dessus des parties émettrices et des parties de base, à l'emplacement des contacts brasés ultérieurs et au-dessus des perforations ménagées dans la première et la deuxième couche métallique (couches 2, 4) de perforations plus petites qu'elles et
j) une couche métallique brasée de contact en un matériau apte à être brasé ou à être renforcé par voie chimique ou galvanique est déposée localement à l'emplacement des contacts brasés ultérieurs, et ce de telle sorte qu'à l'emplacement des points brasés d'émetteur, elle assure le contact avec la première couche métallique (couche 2) et qu'à l'emplacement des points brasés de base, elle assure le contact avec la deuxième couche métallique (couche 4).
